# EUROPÄISCHE PATENTSCHRIFT

(11) **EP 1 198 433 B1**
(45) Veröffentlichungstag und Bekanntmachung des Hinweises auf die Patenterteilung: **16.06.2004**
(21) Anmeldenummer: 00920739.0
(22) Anmeldetag: 26.04.2000
(51) Int. Cl.: C03C 17/42, G02B 1/11

(54) **VERFAHREN UND MITTEL ZUR HERSTELLUNG HYDROPHOBER SCHICHTEN AUF FLUORIDSCHICHTEN UND OPTISCHE SUBSTRATE**
METHOD AND AGENT FOR PRODUCING HYDROPHOBIC LAYERS ON FLUORIDE LAYERS AND OPTICAL SUBSTRATES
PROCEDE ET AGENT POUR PRODUIRE DES COUCHES HYDROPHOBE SUR DES COUCHES DE FLUORURE ET SUBSTRATS OPTIQUES

(30) Priorität: 15.05.1999 DE 19922523
(43) Veröffentlichungstag der Anmeldung: 24.04.2002
(73) Patentinhaber: MERCK PATENT GmbH, 64293 Darmstadt (DE)
(72) Erfinder: ANTHES, Uwe, D-64711 Erbach (DE); DOMBROWSKI, Reiner, D-64739 Höchst (DE); FRIZ, Martin, D-64665 Alsbach (DE)
(86) Internationale Anmeldenummer: PCT/EP2000/003707
(87) Internationale Veröffentlichungsnummer: WO 2000/069785

(56) Entgegenhaltungen:
- EP-A- 0 770 699
- US-A- 5 594 231
- US-A- 5 851 674
- PATENT ABSTRACTS OF JAPAN vol. 016, no. 078 (P-1317), 25. Februar 1992 (1992-02-25) & JP 03 266801 A (NITTO DENKO CORP), 27. November 1991 (1991-11-27)
- PATENT ABSTRACTS OF JAPAN vol. 1995, no. 03, 28. April 1995 (1995-04-28) & JP 06 340966 A (SEIKO EPSON CORP;OTHERS: 01), 13. Dezember 1994 (1994-12-13)

## Beschreibung

Die Erfindung betrifft ein Verfahren und Mittel zur Herstellung hydrophober Schichten auf Fluorid-Substraten bzw. auf Fluorid-Schichten durch Aufdampfen im Vakuum und optische substrate.

In der Optik werden Antireflexschichten auf optische Bauteile, beispielsweise Linsen, Brillengläser, Objektive, Femgläser, Prismen und Spiegel, zur Verminderung der Reflexion aufgebracht. Auf Substraten aus mineralischem Glas wird häufig eine Magnesiumfluoridschicht oder eine 3-fach-Schicht mit der Schichtfolge Aluminiumoxid - Zirkonoxid oder hochbrechende Mischoxide wie Titanoxid/Lanthanoxid - Magnesiumfluorid als Antireflexschicht eingesetzt. Diese Schichten sind aber sehr empfindlich gegenüber Verschmutzung, zum Beispiel durch Fingerabdrücke. Sie sind außerdem schwierig zu reinigen, da die Oberfläche der aufgedampften Magnesiumschichten eine gewisse Rauhigkeit besitzt.

In der Optik werden aber auch häufig Fenster aus Fluoriden, beispielsweise Magnesiumfluorid, Calciumfluorid, Bariumfluorid oder Lithiumfluorid, verwendet. Auch die Oberflächen dieser Bauteile müssen gegen Verschmutzen, Zerkratzen und die Adsorption von Wasser durch eine zusätzliche Beschichtung geschützt werden.

Wasser- und schmutzabweisende Beschichtungen für optische Bauteile sind bekannt. DE 195 39 789 beschreibt ein Verfahren und Mittel zur Herstellung von wasserabweisenden Beschichtungen auf optischen Substraten durch thermisches Bedampfen mit fluorierten Organosilan-Verbindungen im Hochvakuum. Auf Oxidschichten werden haftfeste und haltbare Schutzschichten erhalten, die eine sehr gute Widerstandsfähigkeit gegenüber Wischen und Kratzen zeigen und eine hohe Stabilität gegen feuchtwarme Luft, physiologische Kochsalzlösung und UV-Strahlung besitzen.

in der nicht vorveröffentlichten DE 198 25 100 wird ein Mittel zur Herstellung von wasserabweisenden Beschichtungen auf optischen Schichten beschrieben, das aus einem porösen, elektrisch leitenden Formkörper und einem fluorierten Organosilan besteht. Dieses Mittel hat den Vorteil, daß es infolge seiner elektrischen Leitfähigkeit problemlos in einem Elektronenstrahlverdampfer eingesetzt werden kann und eine genau regelbare Verdampfung der organischen Siliciumverbindungen möglich ist.

Die genannten Verfahren und Mittel haben den Nachteil, daß man mit ihnen keine haftfesten Schichten auf Magnesiumfluorid und anderen Erdalkalimetall- bzw. Alkalimetallfluoriden erzeugen kann.

Aus der Beschichtungstechnik ist die Eigenschaft von Polyfluorkohlenwasserstoff bekannt, wasser- und schmutzabweisende Oberflächen zu bilden. Infolge ihrer hohen Chemikalien- und Temperaturbeständigkeit werden sie als Beschichtungsmaterial im chemischen Apparatebau eingesetzt. Es wurde auch versucht, Polyfluorkohlenwasserstoffe für Interferenzschichten auf optischen Substraten zu verwenden.

R. Chow et al. Proc SPIE 2253 (1994) 512 beschreiben Versuche zur Herstellung von Interferenzschichten durch Verdampfen von PTFE-Copolymer aus Schiffchen im Hochvakuum. Die erhaltenen Schichten werden als sehr weich, wärmeempfindlich und für Interferenzschichten unbrauchbar beschrieben.

Aufgabe der Erfindung ist es, ein Verfahren und Mittel bereitzustellen, das die Herstellung von haftfesten und wischfesten wasser- und schmutzabweisenden Schichten auf Erdalkalimetall- und Alkalimetallfluoridschichten gestattet.

Diese Aufgabe wird gemäß der Erfindung gelöst durch ein Verfahren zur Herstellung hydrophober Beschichtungen auf optischen Substraten, die als äußerste Schicht eine Erdalkalimetall- oder Alkalimetallfluoridschicht besitzen oder aus Erdalkalimetall- oder Alkalimetallfluoriden bestehen durch thermisches Bedampfen mit Polyfluorkohlenwasserstoffen im Hochvakuum.

Diese Aufgabe wird weiterhin gemäß der Erfindung gelöst durch ein Mittel zur Herstellung hydrophober Schichten auf Erdalkalimetall- und Alkalimetallfluoridschichten, umfassend einen porösen, anorganischen Formkörper und einen Polyfluorkohlenwasserstoff, erhältlich durch
a) Mischen eines Metalloxids oder eines Silikates mit einer wäßrigen Suspension eines Polyfluorkohlenwasserstoffes unter Zusatz von Wasser in einem Verhältnis von 99 : 1 bis 80 : 20,
b) Trocknen der pastösen Masse bei 60 bis 120 °C und anschließendes Tempern bei 250 bis 400 °C an Luft und
c) Granulieren und Tablettieren des erhaltenen Feststoffes.

Diese Aufgabe wird weiterhin gemäß der Erfindung gelöst durch ein Mittel zur Herstellung hydrophober Schichten auf Erdalkalimetall- und Alkalimetallfluoridschichten, umfassend einen porösen, elektrisch leitfähigen Formkörper und einen Polyfluorkohlenwasserstoff, erhältlich durch
a) Mischen eines Metalloxids oder eines Silikates mit einem Metallpulver und einer wäßrigen Suspension eines Polyfluorkohlenwasserstoffes unter Zusatz von Wasser in einem Verhältnis von 90 : 10 : 1 bis 20 : 80 : 30,
b) Trocknen der pastösen Masse bei 60 bis 120 °C und anschließendes Tempern bei 250 bis 400 °C an Luft und
c) Granulieren und Tablettieren des erhaltenen Feststoffes.

Gegenstand der Erfindung sind auch optische Substrate mit einer Beschichtung, die unter Verwendung des erfindungsgemäßen Mittels durch Bedampfen im Hochvakuum aufgebracht wird.

Gegenstand der Erfindung ist weiterhin die Verwendung von Polyfluorkohlenwasserstoffen zur Herstellung von hydrophoben Schichten auf optischen Substraten, die aus Alkali- oder Erdalkalimetallfluoriden bestehen.

Gegenstand der Erfindung ist auch die Verwendung von Polyfluorkohlenwasserstoffen zur Herstellung von hydrophoben Beschichtungen auf optischen Substraten, die vorher mit dünnen Schichten zur Oberflächenvergütung und/oder Reflexionsverminderung versehen worden sind, wobei die äußerste Schicht aus Alkali- oder Erdalkalifluoriden besteht.

Die zum Einsatz kommenden Polyfluorkohlenwasserstoffe sind bekannt und im Handel erhältlich. Bevorzugt werden Polytetrafluorethylen (PTFE) und Perfluor-Alkoxy-Polymere (PFA) eingesetzt. Letztere resultieren aus der Copolymerisation von Tetrafluorethylen und Perfluoralkoxyvinylethern.

Es hat sich gezeigt, daß die Polyfluorkohlenwasserstaffe im Hochvakuum durch Erhitzen auf 400 bis 500 °C bei einem Druck von 10⁻³ bis 10⁻⁵ mbar ohne weiteres verdampft werden können, wobei sie sich auf dem Substrat unter Bildung dünner Schichten niederschlagen. Es sind Schichtdicken von 5 bis 20 nm erforderlich.

Für das erfindungsgemäße Verfahren können Hochvakuumbedampfungsanlagen eingesetzt werden, wie sie zur Erzeugung optischer Schichten, wie insbesondere Antireflexschichten oder Vergütungsschichten zur Oberflächenhärtung üblich sind. Hierbei werden die Polyfluorkohlenwasserstoffe in geeigneter Form und Weise, beispielsweise als Granulat, zusätzlich zu den üblichen Bedampfungsmaterialien in der Anlage vorgelegt. Die Verdampfung der Polyfluorkohlenwasserstoffe erfolgt aus einem üblichen Schiffchen, das durch direkten Stromdurchgang oder durch Beschuß mit einem Elektronenstrahl beheizt wird. Zweckmäßig ist der direkte Anschluß des Bedampfungsschrittes an vorangehende Bedampfungsprozesse, etwa zur Aufbringung von Antireflexschichten. Besonders haltbare Schichten werden erhalten, wenn das Substrat auf Temperaturen bis 300 °C erwärmt wird.

Die hydrophoben Schichten können auf Interferenzschichten, beispielsweise Antireflexschichten, Filter, Strahlteiler oder anderen optischen Bauteilen oder Schichten aufgebracht werden. Diese Schichten bestehen entweder aus einer einzelnen niedrigbrechenden Schicht aus Magnesiumfluorid oder einem anderen Erdalkali- oder Alkalimetallfluorid oder aus der Abfolge von hoch- und niedrigbrechenden Schichten, wobei die äußerste Schicht aus Magnesiumfluorid oder einem anderen Erdalkali- oder Alkalimetallfluorid gebildet wird. Weiterhin können die hydrophoben Schichten auf einkristalline Scheiben aus Fluoriden, wie Magnesiumfluorid, Bariumfluorid oder Lithiumfluorid, beispielsweise für optische Fenster, aufgebracht werden. Nach Aufbringen der Vergütungsschichten ist keine weitere Vorbehandlung der Substrate vor dem Bedampfen mit den Polyfluorkohlenwasserstoffen notwendig.

Die Polyfluorkohlenwasserstoffe werden in üblichen Schiffchen in der Bedampfungsanlage vorgelegt. Eine besonders zweckmäßige Form, die Polyfluorkohlenwasserstoffe in der Bedampfungsanlage vorzulegen, ist ein poröser anorganischer Formkörper.

Es wurde gefunden, daß poröse Formkörper aus Metalloxiden oder Silikaten, die auch zusätzlich Metallpulver enthalten können, sehr gut als Trägermaterial für Polyfluorkohlenwasserstoffe geeignet sind und aus diesem Trägermaterial durch Erhitzen, insbesondere auch mit einem Elektronenstrahl, die Polyfluorkohlenwasserstoffe mit einer sehr gut kontrollierbaren Geschwindigkeit verdampft werden können. Unter Formkörper im Sinne der Erfindung werden Granulate mit einer Korngröße von 1 bis 4 mm und Tabletten mit einem Durchmesser von 5 bis 25 mm und einer Dicke von 3 bis 15 mm verstanden.

Als Metalloxide für die porösen Formkörper werden Siliciumdioxid, Aluminiumoxid, Zirkonoxid, Magnesiumoxid oder Mischungen dieser Oxide verwendet. Als Silikate werden Aluminiumsilikate eingesetzt, wobei Mullit bevorzugt wird. Die Formkörper enthalten 15 bis 90 Gew.-% dieser Metalloxide bzw. Silikate. Die Korngröße der Metalloxide oder Silikate liegt zwischen 0,5 und 50 µm.

Die zweite Komponente der porösen Formkörper besteht aus Pulvern der Metalle Silicium, Titan oder Chrom. Die Metallpulver besitzen Partikelgrößen von 5 bis 50 µm. Die Formkörper enthalten 10 bis 65 Gew.-% dieser Metalle.

Die Polyfluorkohlenwasserstoffe können als Pulver oder als wässrige Suspension verwendet werden. Bevorzugt sind aber wässrige Suspensionen, die im Handel erhältlich sind, weil dadurch die Herstellung einer homogenen Mischung mit den beiden anderen Komponenten leichter möglich ist. Der Gehalt der Formkörper an Polyfluorkohlenwasserstoffen beträgt 1 bis 25 Gew.-%, vorzugsweise 5 bis 15 Gew.-%.

Mit dem erfindungsgemäßen Verfahren können haftfeste und wischfeste hydrophobe Schichten auf Erdalkali- und Alkalimetallfluoridschichten erzeugt werden. Die erzeugten Schichten bilden gegenüber Wasser einen Benetzungswinkel von 100 bis 130°. Wassertropfen perlen von der Schicht ab. Schmutz, wie beispielsweise Fingerabdrücke, kann leicht abgewischt werden.

Die folgenden Beispiele sollen die Erfindung erläutern, ohne sie zu begrenzen.

### Beispiel 1:

Es wird eine Mischung aus 90 Gew.-% Mullit (Aluminiumsilikat) und 10 Gew.-% PFA hergestellt. Das PFA wird als wäßrige Suspension mit einem Feststoffgehalt von 50 Gew.-% verwendet. Zur Verbesserung der Mischbarkeit wird Wasser zugesetzt, bis eine pastöse Masse entsteht. Die Masse wird getrocknet und anschließend bei 350 °C an Luft getempert. Danach wird die Mischung granuliert und tablettiert, wobei Tabletten mit einem Durchmesser von 13 mm und einer Dicke von 7 mm erhalten werden.

### Beispiel 2:

Es wird eine Mischung aus 54 Gew.-% Mullit, 36 Gew.-% Siliciumpulver und 10 Gew.-% PFA in Form eines Pulvers hergestellt. Zur Verbesserung der Mischbarkeit wird Wasser zugesetzt, bis eine pastöse Masse entsteht. Die Masse wird bei 80 °C getrocknet und anschließend granuliert und tablettiert.

### Beispiel 3:

In einer konventionellen Aufdampfanlage (L560 von Leybold Systems) werden zu beschichtende Glasscheiben, die vorher gereinigt wurden, auf einem Substratträger befestigt und auf 280 °C aufgeheizt. Die Anlage wird dann bis auf einen Restdruck von 2 x 10⁻⁵ mbar evakuiert. Anschließend wird ein Antireflexschichtsystem bestehend aus Aluminiumoxid (Schichtdicke: 78 nm), Zirkonoxid (Schichtdicke: 124 nm) und Magnesiumfluorid (Schichtdicke: 92 nm) aufgebracht. Dann wird eine nach Beispiel 1 hergestellte Tablette in einem Schiffchen der Verdampfereinrichtung eingebracht und auf 480 °C erhitzt. Das in der Tablette enthaltene PFA verdampft und schlägt sich auf den Glasscheiben unter Schichtbildung nieder. Dabei wird die Temperatur des Substrates immer noch auf 280 °C gehalten. Anschließend werden die beschichteten Gläser abkühlen gelassen und der Anlage entnommen. Die Schichtdicke auf den Substraten wird zu 15 nm bestimmt. Die aufgedampfte hydrophobe Schicht ist haftfest, wischfest und haltbar. Der Kontaktwinkel zu Wasser beträgt 120 °. Er ändert sich nach Wischen mit einem trockenen Baumwolltuch, nach Wischen mit einem mit Alkohol getränktem Tuch, nach Lagern in feucht-warmer Atmosphäre oder nach 10-minütigem Kochen in Wasser nur wenig.

## Patentansprüche

1. Verfahren zur Herstellung hydrophober Schichten auf optischen Substraten, die als äußerste Schicht eine Erdalkalimetall- oder Alkalimetallfluoridschicht besitzen oder aus Erdalkalimetall- oder Alkalimetallfluoriden bestehen, durch thermisches Bedampfen mit Polyfluorkohlenwasserstoffen im Hochvakuum.

2. Verfahren nach Anspruch 1, **dadurch gekennzeichnet, daß** man die Bedampfung bei einem Druck von 10⁻³ bis 10⁻⁵ mbar vornimmt.

3. Verfahren nach Anspruch 1 oder 2, **dadurch gekennzeichnet, daß** der Polyfluorkohlenwasserstoff Polytetrafluorethylen oder ein Perfluor-Alkoxy-Polymer ist.

4. Verfahren nach mindestens einem der Ansprüche 1 bis 3, **dadurch gekennzeichnet, daß** man den Polyfluorkohlenwasserstoff in einem porösen, anorganischen Formkörper vorlegt.

5. Verfahren nach mindestens einem der Ansprüche 1 bis 4, **dadurch gekennzeichnet, daß** man die Polyfluorkohlenwasserstoffe oder den Formkörper auf 400 bis 500 °C erhitzt.

6. Mittel zur Herstellung hydrophober Schichten auf optischen Substraten, die als äußerste Schicht eine Erdalkalimetall- oder Alkalimetallfluoridschicht besitzen oder aus Erdalkalimetall- oder Alkalimetallfluoriden bestehen, umfassend einen porösen anorganischen Formkörper und einen Polyfluorkohlenwasserstoff, erhältlich durch
a) Mischen eines Metalloxids oder eines Silikates mit einer wäßrigen Suspension eines Polyfluorkohlenwasserstoffes unter Zusatz von Wasser in einem Verhältnis von 99 : 1 bis 80 : 20,
b) Trocknen der pastösen Masse bei 60 bis 120 °C und anschließendes Tempern bei 250 bis 400 °C an Luft und
c) Granulieren und Tablettieren des erhaltenen Feststoffes.

7. Mittel zur Herstellung hydrophober Schichten auf optischen Substraten, die als äußerste Schicht eine Erdalkalimetall- oder Alkalimetallfluoridschicht besitzen oder aus Erdalkalimetall- oder Alkalimetallfluoriden bestehen, umfassend einen porösen, elektrisch leitfähigen, anorganischen Formkörper und einen Polyfluorkohlenwasserstoff, erhältlich durch
a) Mischen eines Metalloxids oder eines Silikates mit einem Metallpulver und einer wäßrigen Suspension eines .Polyfluorkohlenwasserstoffes unter Zusatz von Wasser in einem Verhältnis von 90 : 10 : 1 bis 20 : 80: 30,
b) Trocknen der pastösen Masse bei 60 bis 120 °C und anschließendes Tempern bei 250 bis 400 °C an Luft und
c) Granulieren und Tablettieren des erhaltenen Feststoffes.

8. Mittel nach Anspruch 6 oder 7, **dadurch gekennzeichnet, daß** der Polyfluorkohlenwasserstoff Polytetrafluorethylen oder ein Perfluor-Alkoxy-Polymer ist.

9. Mittel nach mindestens einem der Ansprüche 6 bis 8, **dadurch gekennzeichnet, daß** das Metalloxid Siliciumdioxid, Aluminiumoxid, Zirkonoxid, Magnesiumoxid oder ein Gemisch aus diesen Oxiden ist.

10. Mittel nach Anspruch 6 oder 7, **dadurch gekennzeichnet, daß** das Silikat ein Aluminiumsilikat ist.

11. Mittel nach Anspruch 7, **dadurch gekennzeichnet, daß** das Metall Silicium, Titan oder Chrom ist.

12. Verwendung von Polyfluorkohlenwasserstoffen zur Herstellung von hydrophoben Schichten auf optischen Substraten, die aus Alkali- oder Erdalkalimetallfluoriden bestehen.

13. Verwendung von Polyfluorkohlenwasserstoffen zur Herstellung von hydrophoben Schichten auf optischen Substraten, die vorher mit dünnen Schichten zur Oberflächenvergütung und/oder Reflexionsverminderung versehen worden sind, wobei die äußerste Schicht aus Alkali- oder Erdalkalifluoriden besteht.

14. Optische Substrate, die als äußerste Schicht eine Erdalkalimetall- oder Alkalimetallfluoridschicht besitzen oder aus Erdalkali- oder Alkalimetallfluoriden bestehen, mit einer hydrophoben Schicht, die unter Verwendung eines Mittels gemäß den Ansprüchen 6 bis 11 durch Bedampfen im Hochvakuum aufgebracht wird.

## Claims

1. Process for the production of hydrophobic layers on optical substrates which have an alkaline earth metal fluoride or alkali metal fluoride layer as the outermost layer or consist of alkaline earth metal fluorides or alkali metal fluorides, by thermal vapour deposition with polyfluorohydrocarbons in a high vacuum.

2. Process according to Claim 1, **characterized in that** the vapour deposition is carried out at a pressure of from 10⁻³ to 10⁻⁵ mbar.

3. Process according to Claim 1 or 2, **characterized in that** the polyfluorohydrocarbon is polytetrafluoroethylene or a perfluoroalkoxy polymer.

4. Process according to at least one of Claims 1 to 3, **characterized in that** the polyfluorohydrocarbon is introduced in a porous, inorganic moulding.

5. Process according to at least one of Claims 1 to 4, **characterized in that** the polyfluorohydrocarbons or the moulding are/is heated to from 400 to 500°C.

6. Composition for the production of hydrophobic layers on optical substrates which have an alkaline earth metal fluoride or alkali metal fluoride layer as the outermost layer or consist of alkaline earth metal fluorides or alkali metal fluorides, comprising a porous, inorganic moulding and a polyfluorohydrocarbon obtainable by
a) mixing a metal oxide or a silicate with an aqueous suspension of a polyfluorohydrocarbon with addition of water in a ratio of from 99:1 to 80:20,
b) drying the pasty material at from 60 to 120°C and subsequently heating the material at from 250 to 400°C in air, and
c) granulating and tabletting the resultant solid.

7. Composition for the production of hydrophobic layers on optical substrates which have an alkaline earth metal fluoride or alkali metal fluoride layer as the outermost layer or consist of alkaline earth metal fluorides or alkali metal fluorides, comprising a porous, electrically conductive, inorganic moulding and a polyfluorohydrocarbon obtainable by
a) mixing a metal oxide or a silicate with a metal powder and an aqueous suspension of a polyfluorohydrocarbon with addition of water in a ratio of from 90:10:1 to 20:80:30,
b) drying the pasty material at from 60 to 120°C and subsequently heating the material at from 250 to 400°C in air, and
c) granulating and tabletting the resultant solid.

8. Composition according to Claim 6 or 7, **characterized in that** the polyfluorohydrocarbon is polytetrafluoroethylene or a perfluoroalkoxy polymer.

9. Composition according to at least one of Claims 6 to 8, **characterized in that** the metal oxide is silicon dioxide, aluminium oxide, zirconium oxide, magnesium oxide or a mixture of these oxides.

10. Composition according to Claim 6 or 7, **characterized in that** the silicate is an aluminium silicate.

11. Composition according to Claim 7, **characterized in that** the metal is silicon, titanium or chromium.

12. Use of polyfluorohydrocarbons for the production of hydrophobic layers on optical substrates which consist of alkali metal fluorides or alkaline earth metal fluorides.

13. Use of polyfluorohydrocarbons for the production of hydrophobic layers on optical substrates which have been provided in advance with thin layers for surface coating and/or reflection reduction, where the outermost layer consists of alkali metal fluorides or alkaline earth metal fluorides.

14. Optical substrates which have an alkaline earth metal fluoride or alkali metal fluoride layer as the outermost layer or consist of alkaline earth metal fluorides or alkali metal fluorides, having a hydrophobic layer applied by vapour deposition in a high vacuum using a composition according to Claims 6 to 11.

## Revendications

1. Procédé pour la réalisation de couches hydrophobes sur des substrats optiques présentant, comme couche la plus extérieure, une couche d'un fluorure de métal alcalino-terreux ou alcalin ou étant constitués de fluorures de métaux alcalino-terreux ou alcalins par vaporisation thermique de polyfluorohydrocarbures sous un vide poussé.

2. Procédé selon la revendication 1, **caractérisé en ce que** l'on procède à la vaporisation sous une pression comprise entre 10⁻³ et 10⁻⁵ mbar.

3. Procédé selon la revendication 1 ou 2, **caractérisé en ce que** le polyfluorohydrocarbure est le polytétrafluoroéthylène ou un polymère perfluoroalcoxy.

4. Procédé selon au moins l'une des revendications 1 à 3, **caractérisé en ce que** l'on introduit le polyfluorohydrocarbure sous forme d'un corps moulé inorganique, poreux.

5. Procédé selon au moins l'une des revendications 1 à 4, **caractérisé en ce que** l'on chauffe les polyfluorohydrocarbures ou le corps moulé à une température comprise entre 400 et 500°C.

6. Composition pour la réalisation de couches hydrophobes sur des substrats optiques présentant, comme couche la plus extérieure, une couche d'un fluorure de métal alcalino-terreux ou alcalin ou étant constitués de fluorures de métaux alcalino-terreux ou alcalins, comprenant un corps moulé inorganique poreux et un polyfluorohydrocarbure, obtenu par :
a) mélange d'un oxyde métallique ou d'un silicate avec une suspension aqueuse d'un polyfluorohydrocarbure par addition d'eau dans un rapport compris entre 99:1 et 80:20,
b) séchage de la masse pâteuse à une température comprise entre 60 et 120°C, suivi d'un recuit à l'air à une température comprise entre 250 et 400°C et
c) granulation et pastillage de la matière solide obtenue.

7. Composition pour la réalisation de couches hydrophobes sur des substrats optiques présentant, comme couche la plus extérieure, une couche d'un fluorure de métal alcalino-terreux ou alcalin ou étant constitués de fluorures de métaux alcalino-terreux ou alcalins, comprenant un corps moulé, inorganique, poreux, conducteur de l'électricité et un polyfluorohydrocarbure, obtenu par
a) mélange d'un oxyde métallique ou d'un silicate avec une poudre métallique et une suspension aqueuse d'un polyfluorohydrocarbure par addition d'eau dans un rapport compris entre 90:10:1 et 20:80:30,
b) séchage de la masse pâteuse à une température comprise entre 60 et 120°C, suivi d'un recuit à l'air à une température comprise entre 250 et 400°C et
c) granulation et pastillage de la matière solide obtenue.

8. Composition selon la revendication 6 ou 7, **caractérisée en ce que** le polyfluorohydrocarbure est le polytétrafluoroéthylène ou un polymère perfluoroalcoxy.

9. Composition selon au moins l'une des revendications 6 à 8, **caractérisée en ce que** l'oxyde métallique est le dioxyde de silicium, l'oxyde d'aluminium, l'oxyde de zirconium, l'oxyde de magnésium ou un mélange de ces oxydes.

10. Composition selon la revendication 6 ou 7, **caractérisée en ce que** le silicate est un silicate d'aluminium.

11. Composition selon la revendication 7, **caractérisée en ce que** le métal est le silicium, le titane ou le chrome.

12. Utilisation des polyfluorohydrocarbures pour la réalisation de couches hydrophobes sur des substrats optiques constitués par les fluorures de métaux alcalins ou alcalino-terreux.

13. Utilisation des polyfluorohydrocarbures pour la réalisation de couches hydrophobes sur des substrats optiques, préalablement munis de couches minces pour le finissage de surface et/ou pour diminuer la réflexion, la couche la plus extérieure étant constituée par des fluorures de métaux alcalins ou alcalino-terreux.

14. Substrats optiques présentant, comme couche la plus extérieure, une couche d'un fluorure de métal alcalino-terreux ou alcalin ou étant constitués de fluorures de métaux alcalino-terreux ou alcalins, comportant une couche hydrophobe appliquée par vaporisation sous un vide poussé en utilisant une composition conforme aux revendications 6 à 11.
